Europäisches Patentamt

European Patent Office

Office européen des brevets

(19)

(11) Veröffentlichungsnummer: **0 247 455**
**A1**

(12) **EUROPÄISCHE PATENTANMELDUNG**

(21) Anmeldenummer: 87107036.3

(22) Anmeldetag: **15.05.87**

(51) Int. Cl.⁴: **H01L 29/06**

(30) Priorität: **30.05.86 CH 2191/86**

(43) Veröffentlichungstag der Anmeldung:
**02.12.87 Patentblatt 87/49**

(84) Benannte Vertragsstaaten:
**CH DE FR GB IT LI NL SE**

(71) Anmelder: **BBC Brown Boveri AG**

**CH-5401 Baden(CH)**

(72) Erfinder: **Voboril, Jan**
**Landschreiberstrasse 2**
**CH-5401 Baden(CH)**

(54) Halbleiterbauelement sowie Verfahren zu dessen Herstellung.

(57) Bei einem Halbleiterbauelement mit einem dotierten Halbleitersubstrat (1), in das von oben eine entgegengesetzt dotierte obere Dotierungszone (3) eingebracht ist, und einen P-N-Uebergang (2) bildet, der im Randbereich an die Oberfläche tritt, wird zur Verbesserung der Sperrspannungsfähigkeit unterhalb des Oberflächendurchtritts des P-N-Uebergangs (2) eine im Halbleitersubstrat (1) vergrabene, entgegengesetzt dotierte, untere Dotierungszone (15) angeordnet, welche die Ladungsträgerkonzentration im kritischen Bereich herabsetzt.

Diese Struktur zeichnet sich durch eine Beibehaltung der planaren Oberfläche und eine leichte Herstellbarkeit aus.

FIG.2

## Halbleiterbauelement sowie Verfahren zu dessen Herstellung

Die vorliegende Erfindung betrifft ein Halbleiterbauelement mit einem innerhalb eines dotierten Halbleitersubstrats verlaufenden P-N-Uebergang sowie ein Verfahren zu dessen Herstellung. Ein solches Bauelement ist z.B. aus dem Artikel von V.P. Sundersingh und A.A. Ghatol, Int. J. Electronics, Vol. 54, No. 1 (1983), S. 127 ff. bekannt.

Bei Halbleiterbauelementen mit einem innerhalb eines Halbleitersubstrats verlaufenden P-N-Uebergang wird die Spannungsfestigkeit des in Sperrichtung vorgespannten P-N-Uebergangs nicht so sehr durch die Volumeneigenschaften des Halbleitersubstrats bestimmt, sondern vor allem durch Oberflächeneffekte an den Stellen, an denen der P-N-Uebergang im Substrat an die Oberfläche tritt.

Um die nach den Volumeneigenschaften des Halbleitermaterials zu erwartende, volle Sperrspannungsbelastbarkeit des P-N-Uebergangs nutzen zu können, muss das elektrische Feld in dem Bereich, wo der P-N-Uebergang an die überfläche tritt, in geeigneter Weise beeinflusst werden, damit das Maximum der dort herrschenden Feldstärke begrenzt wird. Dies hat seinen Grund darin, dass an der überfläche ein Durchbruch bereits bei kleineren Feldstärken stattfindet, als im Volumen des Halbleitermaterials.

Das zu beeinflussende elektrische Feld wird in bekannter Weise durch die am P-N-Uebergang sich bildende Raumladungszone hervorgerufen, welche eine Folge der Diffusion der freien Ladungsträger und der von aussen anliegenden Spannung ist.

Es sind nun im Stand der Technik verschiedene Massnahmen vorgeschlagen worden, um die maximal auftretende Feldstärke an der Oberfläche eines Halbleiterbauelements zu reduzieren (ein Ueberblick darüber kann den beiden Druckschriften: J.A. Tove in J. Phys. D: Appl. Phys., 15 (1982), S. 517-536 sowie R. Denning und J. White in Solid State Technology, März 1980, S. 98-105, entnommen werden):

1) Eine der bekannten Massnahmen besteht darin, im kritischen Randbereich des Bauelements, wo der P-N-Uebergang an die Oberfläche tritt, die Menge der verfügbaren Ladungen zu reduzieren und damit die Feldstärke in der Raumladungszone herabzusetzen. Dies kann realisiert werden

a) durch eine negative Anschrägung im Randbereich (negative bevelling) bzw. einen ausgeätzten Trenngraben, die beide den P-N-Uebergang schneiden;

b) durch eine Mesastruktur im Randbereich der einen Dotierungszone;

c) durch einen den P-N-Uebergang umgebenden, eindiffundierten Schutzring (guard ring).

2) Eine weitere, aus dem eingangs genannten Artikel von V.P. Sundersingh et al. bekannte Massnahme besteht darin, die eine, stark dotierte Dotierungszone des P-N-Uebergangs im Randbereich mit schwächer werdender Dotierung auslaufen zu lassen, um so die verfügbaren Ladungsträger herabzusetzen.

3) Eine dritte, aus einem Artikel von V.A.K. Temple in IEDM Techn. Digest 1977, S. 423-426 bekannte Massnahme sieht einen lateralen Dotierungsgradienten im Randbereich vor, der unter Beibehaltung einer planaren Oberfläche dieselbe Wirkung hat, wie die Massnahmen unter Punkt 1).

4) Weiterhin ist es bekannt (z.B. aus dem angeführten Artikel von P.A. Tove), das elektrische Feld im Bereich des Oberflächendurchtritts des P-N-Uebergangs mit Hilfe einer darüberliegenden Elektroden-Feldplatte zu beeinflussen.

5) Schliesslich muss noch auf diejenigen Massnahmen hingewiesen werden, die sich nicht auf Eingriffe in die dünnere, hochdotierte Dotierungszone beziehen, sondern auf Eingriffe in die dicke, niedrig dotierte Zone, d.h. das zugrundeliegende Halbleitersubstrat. Hier sind bekannt

a) die positive Anschrägung im Randbereich (positive bevelling); und

b) das Abätzen des Substratmaterials (substrate etch).

Zu allen aufgeführten, bekannten Massnahmen ist zu bemerken, dass diejenigen Varianten, bei welchen die planare Oberfläche des Bauelements erhalten bleibt, zunehmend an Bedeutung gewinnen.

Weiterhin besitzt in der Regel die obenliegende Dotierungszone (die meist vom p-Typ ist) eine wesentlich höhere Dotierungskonzentration und eine sehr viel geringere Dicke als die darunterliegende Substratschicht (die entsprechend meist vom n-Typ ist). Sofern sich daher die bekannten Massnahmen (wie unter den Punkte 1) bis 4) aufgeführt) auf Eingriffe in der dünnen, höher dotierten oberen Dotierungszone beziehen, haben sie den Nachteil, dass sie mit grosser Genauigkeit erfolgen müssen. Bereits eine geringe Abweichung vom idealen Zustand stellt den Erfolg der Massnahme zumindestens in Frage.

Schliesslich sind die unter Punkt 5) aufgeführten Varianten zwar weitgehend unempfindlich bezüglich der Einstellung des Anschräg-Winkel bzw. der Aetztiefe. Die Anschrägung a) verlangt jedoch eine mechanische Bearbeitung des Halbleitermaterials, welche mit Defektbildung verbunden ist und eine nachträgliche Aetzung erforderlich macht. Die Aetzung b) erfordert wegen der Dicke des Substrats sehr lange Aetzzeiten, die erhöhte Anforderungen an die Beständigkeit der Aetzmaske stellen. Hinzu kommt eine erhöhte Bruchanfälligkeit dieser Struktur.

Aufgabe der vorliegenden Erfindung ist es nun, ein Halbleiterbauelement anzugeben, das bei Erhaltung der planaren Oberfläche eine erhöhte Sperrspannungsfestigkeit aufweist und sich vergleichsweise einfach herstellen lässt.

Die Aufgabe wird bei einem Halbleiterbauelement der eingangs genannten Art durch die Merkmale aus dem Kennzeichen des Anspruchs 1 gelöst.

Der Kern der Erfindung besteht darin, im Randbereich des Halbleiterbauelements, in dem der durch eine dünne obere Dotierungszone und das darunterliegende Substrat gebildete P-N-Uebergang an die Oberfläche tritt, unterhalb des P-N-Uebergang im Volumen des Substrats eine entgegengesetzt dotierte untere Dotierungszone vorzusehen, die im Volumen des Substrats die verfügbaren Ladungsträger begrenzt und so die maximale Feldstärke im Bereich des Oberflächendurchtritts des P-N-Uebergangs herabsetzt.

Gemäss einem bevorzugten Ausführungsbeispiel der Erfindung wird die untere Dotierungszone sogar vollständig im Volumen des Halbleitersubstrats vergraben (buried zone), indem zur unteren Seite hin eine zusätzliche Stoppschicht in das Substrat eingebracht wird, welche die untere Dotierungszone nach unten hin begrenzt, so dass die untere Dotierungszone allseitig von entgegengesetzt dotiertem Substratmaterial umgeben ist.

Bei dem erfindungsgemässen Verfahren zur Herstellung des Halbleiterbauelements wird zunächst in das dotierte Halbleitersubstrat von der zweiten, unteren Seite her durch eine tiefe, selektive Diffusion die entgegengesetzt dotierte, untere Dotierungszone eingebracht und erst in einem zweiten Schritt wird durch eine maskierte Diffusion von der ersten, oberen Seite des Substrats her die obere, entgegengesetzt dotierte Dotierungszone erzeugt.

Weitere Ausführungsbeispiele für die Erfindung ergeben sich aus den Unteransprüchen.

Die Erfindung soll nun nachfolgend im Zusammenhang mit der Zeichnung anhand von Ausführungsbeispielen näher erläutert werden. Es zeigen:

Fig. 1A-1K verschiedene bekannte Massnahmen zur Reduzierung der maximalen Feldstärke im Randbereich eines Halbleiterbauelements mit einem an die Oberfläche tretenden P-N-Uebergang;

Fig. 2 ein erstes Ausführungsbeispiel fur ein Halbleiterbauelement nach der Erfindun;

Fig. 3A-3D verschiedene Stufen bei der Herstellung eines Halbleiterbauelements gemäss Fig. 2;

Fig. 4 ein zweites Ausführungsbeispiel für ein Halbleiterbauelement nach der Erfindung; und

Fig. 5 und 6 ein drittes und viertes Ausführungsbeispiel für ein Halbleiterbauelement nach der Erfindung.

In der Folge der Figuren 1A bis 1K sind eine Anzahl verschiedener Massnahmen zur Verringerung der elektrischen Feldstärke im Bereich des Oberflächendurchtritts eines P-N-Uebergangs veranschaulicht, wie sie aus dem Stand der Technik bekannt sind.

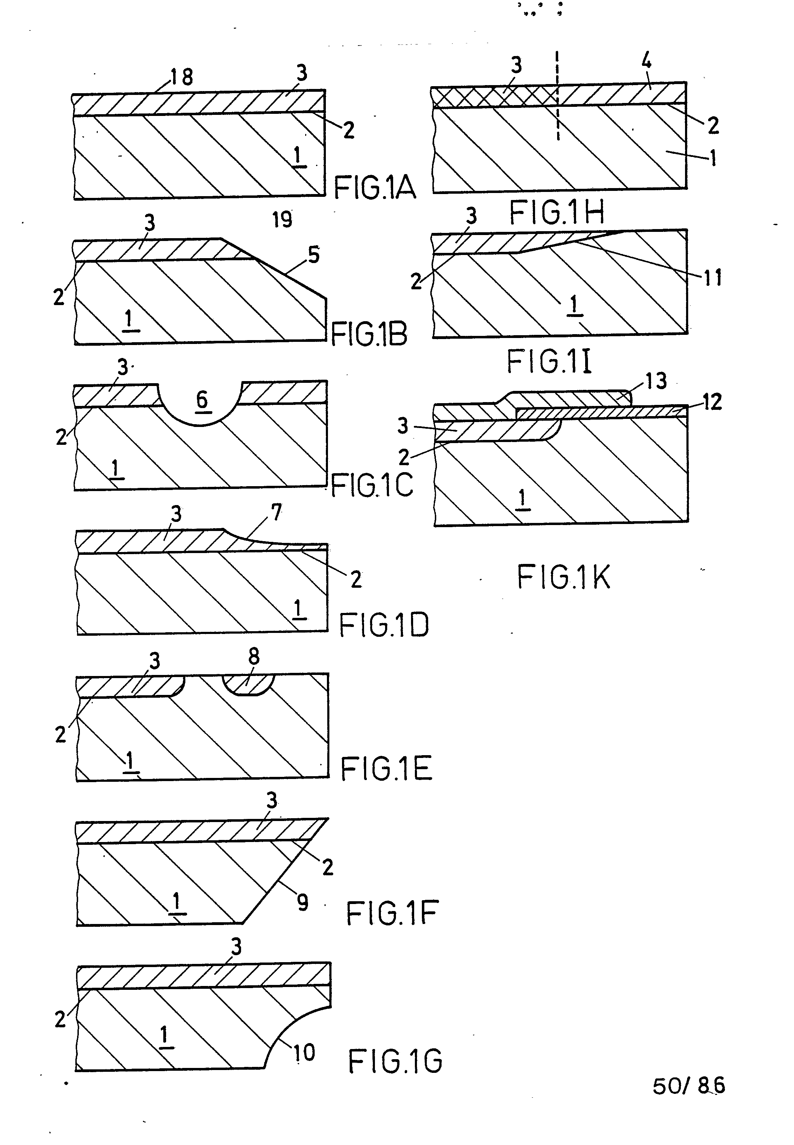

Ausgehend von einer grundlegenden Bauelementstruktur (Fig. 1A), die zwischen einer ersten, oberen Seite 18 und einer zweiten, unteren Seite 19 ein Halbleitersubstrat 1 aufweist, welches meist schwächer dotiert ist, und in welches von der oberen Seite 18 her eine stärker und entgegengesetzt dotierte obere Dotierzone 3 eingebracht ist und mit dem Halbleitersubstrat 1 zusammen einen P-N-Uebergang 2 bildet, besteht eine erste bekannte Massnahme darin, am Rande des Substrats durch mechanische Bearbeitung eine negative Anschrägung 5 zu erzeugen (Fig. 1B).

Der negativen Anschrägung in der Wirkung vergleichbar ist ein im Randbereich eingeätzter Graben 6 (Fig. 1C), der den P-N-Uebergang 2 schneidet.

Der P-N-Uebergang 2 selbst wird nicht bei einer anderen Massnahme erreicht, die in Fig. 1D dargestellt ist, der Ausgestaltung der oberen Dotierungszone 3 in Form einer Mesastruktur 7 mit ebenen Plateau und an den Rändern abfallenden Bereichen, die nach aussen hin flacher auslaufen.

Neben den mit geometrischen Aenderungen auf der Oberseite des Halbleitersubstrats 1 verbundenen Massnahmen der Fig. 1B bis 1D sind in den Fig. 1E, 1H und 1I Varianten wiedergegeben, bei denen die obere Seite 18 als planare Oberfläche erhalten bleibt und die Massnahme entweder einen die obere Dotierungszone 3 umgebenden Schutzring 8 gleicher Dotierung vorsieht (Fig. 1E), oder die obere Dotierzone 3 in einem schwächer dotierten Randbereich 4 (Fig. 1H) oder mit einem lateralen Dotierungsgradienten 11 (Fig. 1I) auslaufen lässt.

Eine weitere bekannte Massnahme, welche das Halbleitersubstrat in seiner ursprünglichen Geometrie unverändert lässt, ist das Anbringen einer Feldplatte 13 oberhalb des an die Oberfläche tretenden P-N-Uebergangs 2 mit einer dazwischenliegenden Isolierschicht 12 (Fig. 1K).

Zwei andere bekannte Massnahmen betreffen schliesslich geometrische Veränderungen des Halbleitersubstrats 1 auf der von der oberen Dotierungszone 3 abgewandten Seite im niedrigdotierten Substratteil. Hierzu gehören eine positive Anschrägung 9 (Fig. 1F), welche, wie die negative Anschrägung aus Fig. 1B, eine mechanische Bearbeitung erfordert, sowie eine Substratätzung 10 im unteren Substratbereich (Fig. 1G).

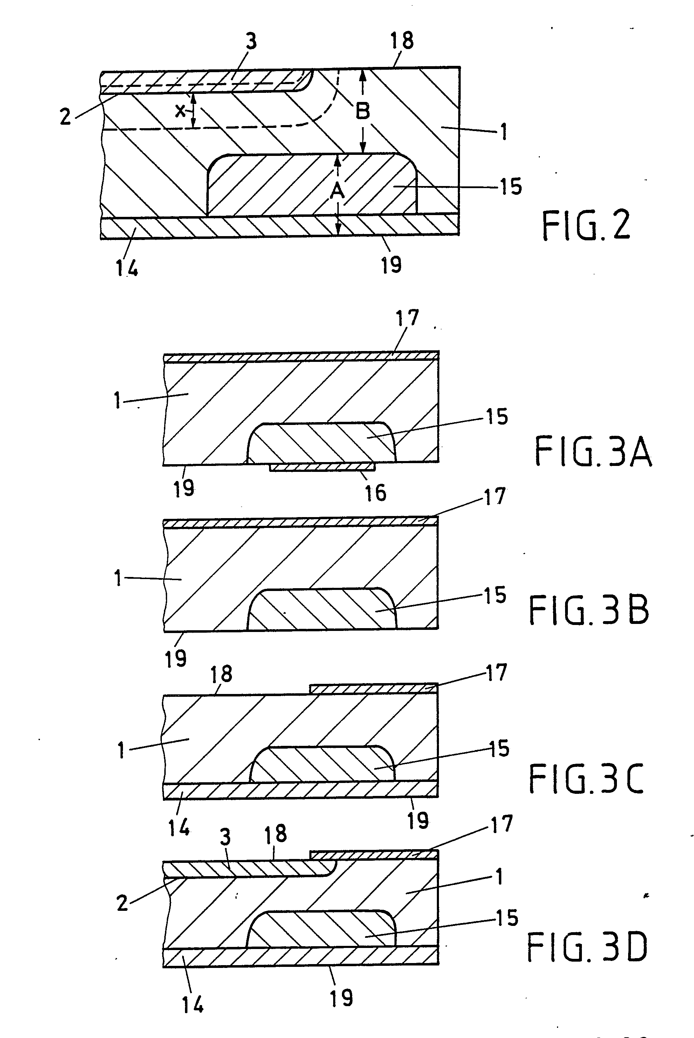

Demgegenüber bleibt die geometrische Gestalt des Halbleitersubstrats 1 bei einem Halbleiterbauelement nach der Erfindung in ihrer ursprünglichen Form erhalten. In dem ersten in Fig. 2 dargestellten Ausführungsbeispiel wird von einem planaren Bauelement ausgegangen, bei dem in ein vergleichsweise dickes, schwach dotiertes Halbleitersubstrat 1 von der ersten, oberen Seite 18 her eine dünne, entgegengesetzt und hoch dotierte, obere Dotierungszone 3, z.B. durch Diffusion, eingelassen ist (in Fig. 2 ist nur der interessierende Randbereich wiedergegeben).

Die obere Dotierungszone 3 bildet zusammen mit dem andersartig dotierten Halbleitersubstrat 1 einen P-N-Uebergang 2, der im Randbereich zur oberen Seite 18 hin an die Oberfläche tritt, und eine gestrichelt eingezeichnete Raumladungszone ausbildet, die mit einer von der anliegenden Spannung abhängigen Raumladungstiefe x in das Halbleitersubstrat 1 hineinreicht.

Unterhalb dieser Durchtrittsstelle ist im Volumen des Halbleitersubstrats 1 eine untere Dotierungszone 15 angeordnet, die eine zum Halbleitersubstrat 1 entgegengesetzte Dotierung aufweist, d.h. in gleicher oder ähnlicher Weise dotiert ist wie die obere Dotierungszone 3. Die Tiefe der unteren Dotierungszone beträgt von der unteren Seite 19 her A, von der oberen Seite her B.

Die untere Dotierungszone 15 ist zur unteren Seite 19 des Halbleitersubstrats 1 hin durch eine Stoppschicht 14 abgeschlossen, die mit gleichem Vorzeichen dotiert ist wie das Halbleitersubstrat 1 selbst. Die untere Dotierungszone 15 stellt damit eine vollständig im Substratvolumen vergrabene, entgegengesetzt dotierte Zone dar.

Die Wirkungsweise der unteren Dotierungszone 15 kann folgendermassen erläutert werden: Das Halbleitersubstrat 1 ist gegenüber der oberen Dotierungszone 3 schwach dotiert (üblicherweise $n^-$ gegenüber p). Der P-N-Uebergang 2 ist daher stark unsymmetrisch und seine Raumladungszone dringt bis zu einer Raumladungstiefe x in das Halbleitersubstrat 1 ein, welche von der angelegten Spannung (in Sperrichtung) U und der Dotierung N des Halbleitersubstrats 1 wie folgt abhängt:

$$x = (\frac{2 \varepsilon U}{qN})^{1/2}$$

($\varepsilon$ = diel. Konst. f. Halbleitermaterial, i.d.R. Si;
q = Elementarladung).

Für das Beispiel $N = 2 \times 10^{13} \, cm^{-3}$ ergeben sich die folgenden Raumladungstiefen in Abhängigkeit von U:

| U: | 10 | 200 | 500 | 1000 | (V) |
|----|----|-----|-----|------|-----|
| x: | 25,6 | 114,3 | 180,7 | 255,5 | ($\mu$m) |

Bei einer Tiefe der unteren Dotierungszone 15 von A = 100 $\mu$m bzw. B = 180 $\mu$m stösst die Raumladungszone des P-N-Uebergangs, da die Dicke der oberen Dotierungszone 3 sehr gering ist, bei einer Sperrspannung von etwa 500 V auf die untere Dotierungszone 15. Diese untere Dotierungszone 15 ist bis zu diesem Punkt elektrisch neutral im Volumen des Halbleitersubstrats vergraben.

Die Raumladungszone besteht aus ortsfesten (bei einem $n^-$-dotierten Halbleitersubstrat 1 positiven) Ladungen, da die entgegengesetzt geladenen freien Ladungsträger (Elektronen) durch die angelegte Spannung abgesaugt worden sind.

Sollte nun die Raumladungszone in die untere Dotierungszone 15 eindringen, könnten höchstens die hier befindlichen, andersartigen freien Ladungsträger (Löcher) in Richtung der entsprechenden Elektrode (Anode) transportiert werden, wobei die übrigbleibenden ortsfesten Ladungen (negative Ladungen) das elektrische Feld in der Raumladungszone schwächen würden.

Tatsächlich ist das Eindringen der Raumladungszone in die untere Dotierungszone 15 jedoch gering, so dass die Wirkung jener der Subtr-tätzung (Fig. 1G) vergleichbar ist.

Aus diesem Grunde können für dieses Ausführungsbeispiel die gleichen Ueberlegungen verwendet werden, wie sie, z.B. in dem Artikel von V.A.K. Temple und M.S. Adler, IEEE Transactions on Electron Devices, Vol. ED-24, No. 8, August 1977, S. 1077 f., für die Substratätzung angestellt worden sind.

Das erfindungsgemässe Halbleiterbauelement in der Ausführungsform der Fig. 2 vereinigt die Vorteile zweier bekannter Halbleiterbauelemente, nämlich die Vorteile des Bauelements mit Schutzring (Fig. 1E) und die des Bauelements mit Substratätzung (Fig. 1G):

-es handelt sich um eine "planare" Variante ohne Eingriff in die (meistens polierte) obere Seite 18 des Halbleiter substrats;

-das Halbleitersubstrat bleibt ungeätzt, so dass keine Schwachstellen entstehen und die Bruchgefahr gebannt ist;

-es gibt praktisch keine Einbusse bei der wirksamen Fläche des Bauelements, d.h. die Variante ist platzsparend;

-die untere Dotierungszone 15 lädt sich zwar ähnlich wie der bekannte Schutzring (8 in Fig. 1E) auf; der beteiligte P-N-Uebergang ist dabei jedoch im Substratvolumen vergraben, so dass Oberflächeneffekte keine Rolle spielen;

-die Anordnung der unteren Dotierungszone 15 kann darüber hinaus mit allen bekannten Massnahmen kombiniert werden, die sich auf die Beeinflussung der oberen Dotierungszone beziehen. Auf diese Weise kann die Wirkungsweise dieser Massnahmen unterstützt, bzw. der Randabschluss entlastet werden.

Um eine Struktur ss ersten Ausführungsbeispiel der Erfindung nach Fig. 2 zu erhalten, kann mit Vorteil ein Verfahren angewandt werden, dssen wesentliche Schritte in der Figurenfolge Fig. 3A-3D dargestellt sind. Für die Erläuterung des Verfahrens wird zusätzlich vorausgesetzt, dass vorzugsweise ein schwach n-dotiertes Halbleitersubstrat 1 den Ausgangspunkt bildet, in welches ein stark p-dotierte obere Dotierungszone 3 und eine p-dotierte untere Dotierungszone 15 sowie eine n-dotierte Stoppschicht 14 eindiffundiert werden.

In das schwach n-dotierte Halbleitersubstrat 1 wird zu Beginn des Verfahrens gemäss Fig. 3A zunächst durch eine tiefe, selektive p-Diffusion von der zweiten unteren Seite 19 her die untere Dotierungszone 15 eingebracht.

Für diese tiefe, selektive p-Diffusion hat sich ein Verfahren bewährt, welches in DE-OS 35 20 699 näher erläutert ist. Bei diesem Verfahren wird auf der zweiten, unteren Seite 19 selektiv eine Aluminiumschicht 16 durch Kathodenzerstäubung abgeschieden und anschliessend in einem Diffusionsprozess als Diffusionsquelle verwendet, von der aus die p-Dotierung der unteren Dotierungszone 15 erfolgt. Bei diesem Diffusionsprozess ist die erste, obere Seite 18 des Halbleitersubstrats 1 durch eine geeignete Abdeckschicht 17, z.B. aus $SiO_2$, geschützt. Daneben kommt für die tiefe Diffusion auch die an sich bekannte Thermomigration in Betracht. Die untere Dotierungszone 15 kann jedoch auch mittels herkömmlicher Diffusion, z.B. mit Bor, in das Substrat eingebracht werden, wenn die Stoppschicht 14 anschliessend epitaktisch auf das Substrat aufgebracht wird.

Im Anschluss an das Eindiffundieren der unteren Dotierungszone 15 wird die zweite, untere Seite 19, in Fig. 3B angedeutet, geläppt und geätzt, um eine möglichst störungsfrei Oberfläche auf der Substrat-Unterseite zu erzielen.

An diesen Oberflächenbearbeitungs-Schritt schliesst sich ein zweiter Diffusionsprozess an, in dem, wiederum von der unteren Seite 19 her ein Donator, z.B. Phosphor, ganzflächig in das Halbleitersubstrat 1 eindiffundiert wird und dort die n-leitende Stoppschicht 14 bildet, welche die untere Dotierungszone 15 nach unten hin begrenzt, so dass diese Zone vollständig im Volumen eingeschlossen ist.

Auch bei diesem Diffusionsschritt ist die Abdeckschicht 17 auf der oberen Seite 18 des Halbleitersubstrats noch ganzflächig vorhanden, um eine unkontrollierte Dotierung auf der Oberseite zu verhindern. Nach Beendigung der zweiten Diffusion wird die Abdeckschicht 17 dann, z.B. photolithographisch, in geeigneter Weise strukturiert, um als Maske bei der Diffusion der oberen Dotierungszone zu dienen (Fig. 3C).

Diese obere Dotierungszone 3 (Fig. 3D) wird dann in einem dritten Diffusionsschritt, z.B. durch Bor-Diffusion oder Implantation, als stark p-dotierte Zone von der oberen Seite 18 her durch die als Maske wirkende Abdeckschicht 17 in das Substrat eingebracht und bildet dann den P-N-Uebergang 2 aus.

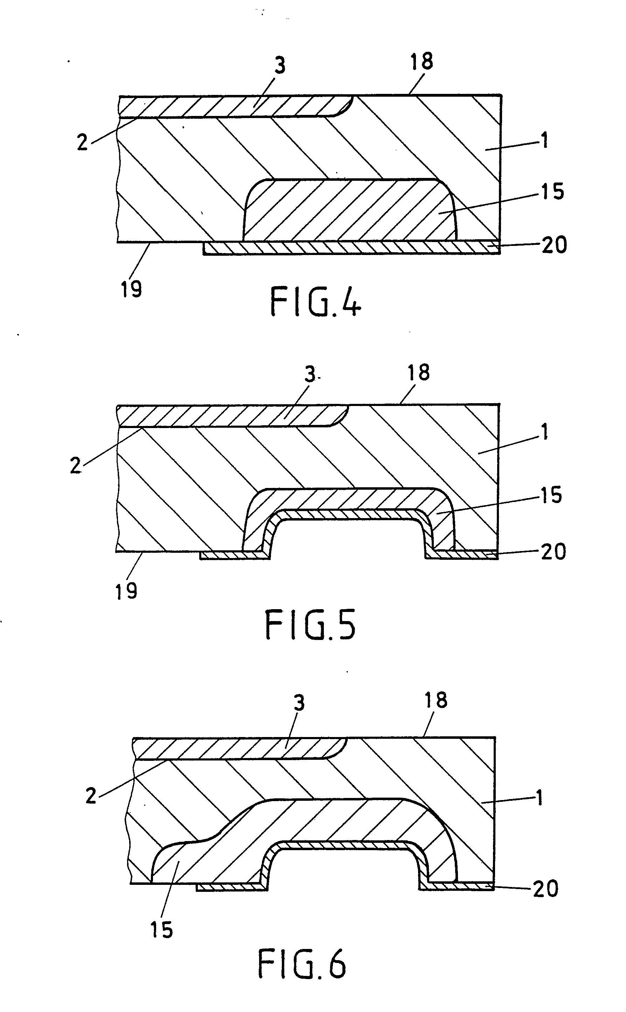

Eine andere Folge von Verfahrensschritten ist notwendig, um zu einem Bauelement gemäss dem zweiten Ausführungsbeispiel der Erfindung (Fig. 4) zu gelangen. Bei diesem Ausführungsbeispiel entfällt der zweite Diffusionsschritt, weil hier auf den unteren Abschluss der unteren Dotierungszone 15 durch eine n-dotierte Stoppschicht (14 in Fig. 2) verzichtet wird.

An die Stelle der fehlenden Stoppschicht tritt hier eine im Randbereich auf die untere Seite 19 aufgebrachte Passivierungsschicht 20 (z.B. aus SiO₂), welche die untere Dotierungszone 15 in ihrer ganzen Breite, einschliesslich der von ihr erzeugten Raumladungszone, abdeckt. Dadurch wird ein Verfahrensschritt eingespart, andererseits jedoch auf ein vollständiges Vergraben der unteren Dotierungszone 15 verzichtet.

Im dritten Ausführungsbeispiel der Fig. 5 schliesslich wird vor dem Eindiffundieren der unteren Dotierungszone 15 zunächst an der entsprechenden Stelle ein Graben 21 durch Aetzen ausgehoben und dann die untere Dotierungszone 15 durch Diffusion in den Boden und die Seitenwände des Grabens 21 erzeugt. Dieses Vorgehen hat den Vorteil, dass die Diffusion nicht so tief zu sein braucht wie im Fall der Fig. 4, bzw. der Eingriff in das Halbleitersubstrat 1 von der unteren Seite 19 her tiefer ausgeführt werden kann.

Die Struktur der Fig. 5 kann zusätzlich wiederum durch eine nicht eingezeichnete Stoppschicht entsprechend der Fig. 2 ergänzt werden, welche die untere Dotierungszone 15 vom Graben 21 und der übrigen unteren Seite 19 abtrennt.

Gemäss einem vierten Ausführungsbeispiel nach Fig. 6 kann die untere Dotierungszone 15 auch unterhalb der oberen Dotierungszone 3 stufig ausgebildet werden. Auf diese Weise lässt sich die Ausdehnung der Raumladungszone mit noch mehr Freiheitsgraden beeinflussen und die Feldstärke in der Raumladungszone besser kontrollieren. Auch hier kann zusätzlich wieder eine Stoppschicht vorgesehen werden.

Insgesamt steht mit Erfindung ein Halbleiterbauelement zur Verfügung, welches ohne die Nachteile bekannter Bauelemente eine erhöhte Sperrspannungsfestigkeit aufweist und einfach zu realisieren ist.

Selbstverständlich liegt es im Rahmen der Erfindung, anstelle der hier angeführten Heissdiffusionsprozesse auch andere aus der Halbleitertechnologie bekannte Dotierungsverfahren und Dotierstoffe zu verwenden, sofern sie nur geeignet sind, eine untere Dotierungszone in vergleichbarer Anordnung zu schaffen. Desgleichen ist es auch denkbar, andere geometrische Formen der Dotierungszonen vorzusehen.

## Ansprüche

1. Halbleiterbauelement mit einem innerhalb eines dotierten Halbleitersubstrats verlaufenden P-N-Uebergang, welcher von dem Halbleitersubstrat und einer von der oberen Seite in das Halbleitersubstrat hineinragenden, entgegengesetzt dotierten, oberen Dotierungszone gebildet wird, und welcher in einem Randbereich des Bauelements an die Oberfläche tritt, dadurch gekennzeichnet, dass zur Verringerung der Ladungen in der Nähe des Oberflächendurchtritts des P-N-Uebergangs (2) eine zum Halbleitersubstrat (1) entgegengesetzt dotierte, untere Dotierungszone (15) angeordnet ist, welche von der unteren Seite (19) des Halbleitersubstrats (1) aus in das Substrat eingebracht worden ist, und im Volumen des Halbleitersubstrats (1) unterhalb des P-N-Uebergangs (2) endet.

2. Halbleiterbauelement nach Anspruch 1, dadurch gekennzeichent, dass das Halbleitersubstrat (1) - schwach n-dotiert, die obere Dotierungszone (3) stark p-dotiert und die untere Dotierungszone (15) p-dotiert sind.

3. Halbleiterbauelement nach Anspruch 1, dadurch gekennzeichnet, dass die untere Dotierungszone (15) seitlich auf den Randbereich des P-N-Uebergangs (2) beschränkt ist.

4. Halbleiterbauelement nach Anspruch 1, dadurch gekennzeichnet, dass die untere Dotierungszone (15) auf der unteren Seite (19) des Halbleitersubstrats (1) an die Oberfläche tritt und dort mit einer Passivierungsschicht (20), vorzugsweise aus SiO₂, abgedeckt ist.

5. Halbleiterbauelement nach Anspruch 4, dadurch gekennzeichnet, dass die untere Dotierungszone (15) auf der unteren Seite (19) einen Graben (21) umschliesst, welcher von der unteren Seite (19) her in das Halbleitersubstrat (1) hineinragt.

6. Halbleiterbauelement nach Anspruch 2, dadurch gekennzeichnet, dass die untere Dotierungszone (15) zur unteren Seite (19) des Halbleitersubstrats (1) hin durch eine in das Halbleitersubstrat (1) eingebrachte, n-dotierte Stoppschicht (14) begrenzt ist.

7. Halbleiterbauelement nach Anspruch 1, dadurch gekennzeichnet, dass der P-N-Uebergang (2) auf der oberen Seite (18) des Halbleitersubstrats (1) an die Oberfläche tritt, und die untere Dotierungszone (15) genau unterhalb dieses Oberflächendurchtritts angeordnet ist.

8. Verfahren zum Herstellen eines Halbleiterbauelements nach Anspruch 1, welches die folgenden Verfahrensschritte umfasst:

a) in das dotierte Halbleitersubstrat (1) wird von der unteren Seite (19) her die entgegengesetzt dotierte, untere Dotierungszone durch eine selektive, tiefe Diffusion eingebracht; und

b) in das Halbleitersubstrat (1) wird anschliessend von der oberen Seite (18) her die entgegengesetzt dotierte, obere Dotierungszone (3) durch eine maskierte Diffusion eingebracht.

9. Verfahren nach Anspruch 8, dadurch gekennzeichnet, dass

a) ein schwach n-dotiertes Halbleitersubstrat (1) verwendet wird;

b) die selektive, tiefe Diffusion der unteren Dotierungszone (15) eine p-Diffusion ist, die das Eindiffundieren einer durch Kathodenzerstäubung selektiv aufgebrachten Aluminiumschicht (16) umfasst; und

c) die maskierte Diffusion der oberen Dotierungszone (3) eine mit einer $SiO_2$-Maske maskierte p-Diffusion, vorzugsweise mit Bor, ist.

10. Verfahren nach Anspruch 9, dadurch gekennzeichnet, dass in das Halbleitersubstrat (1) nach dem Eindiffundieren der unteren Dotierungszone (15) von der unteren Seite (19) des Halbleitersubstrats (1) her eine n-dotierte Stoppschicht (14), vorzugsweise durch Phosphordiffusion, ganzflächig eingebracht wird, welche die untere Dotierungszone (15) zur unteren Seite (19) hin begrenzt.

FIG.1A

FIG.1B

FIG.1C

FIG.1D

FIG.1E

FIG.1F

FIG.1G

FIG.1H

FIG.1I

FIG.1K

FIG.2

FIG.3A

FIG.3B

FIG.3C

FIG.3D

FIG.4

FIG.5

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-1 614 991 (WESTINGHOUSE BRAKE AND SIGNAL CO. LTD) * Figur 4 * | 1,3,4 | H 01 L 29/06 |
| X | PROCEEDINGS OF THE 5TH CONFERENCE ON SOLID STATE DEVICES, TOKYO, 1973, SUPPLEMENT TO THE JOURNAL OF THE JAPAN SOCIETY OF APPLIED PHYSICS, Band 43, 1974, Seiten 395-399, Tokyo, JP; T. MATSUSHITA et al.: "Ultra-high voltage semiconductor devices" * Figur 3 * | 1,4 | |
| A | GB-A-2 033 154 (BBC BROWN, BOVERI & CO. LTD) * Zusammenfassung; Figuren 2,3 * | 1-3 | RECHERCHIERTE SACHGEBIETE (Int. Cl.4) |
| A | FR-A-1 531 252 (UNITRODE CORP.) * Seite 5, Spalte 2, Zeile 47 - Seite 6, Spalte 1, Zeile 11; Figur 8 * | 1,5,8 | H 01 L |
| A | EP-A-0 011 443 (HITACHI LTD) * Figur 7 * | 1,5 | |
| D,A | DE-A-3 520 699 (BBC AG BROWN, BOVERI & CIE) * Insgesamt * | 8-10 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 12-08-1987 | BAILLET B.J.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | INTERNATIONAL JOURNAL OF ELECTRONICS, Band 54, Nr. 1, 1983, Seiten 127-137, Taylor & Francis Ltd, London, GB; V.P. SUNDERSINGH et al.: "Concentration profiling for high voltage p+-n-n+ diodes" ----- | | |
| | | | **RECHERCHIERTE SACHGEBIETE (Int. Cl.4)** |

Der vorliegende Recherchenbericht wurde für alle Patentansprüche erstellt.

| Recherchenort | Abschlußdatum der Recherche | Prüfer |
|---|---|---|
| DEN HAAG | 12-08-1987 | BAILLET B.G.R. |